Europäisches Patentamt

European Patent Office

Office européen des brevets

(11) Veröffentlichungsnummer: **0 484 808 A2**

# EUROPÄISCHE PATENTANMELDUNG

(21) Anmeldenummer: **91118471.1**

(22) Anmeldetag: **30.10.91**

(51) Int. Cl.5: **C23C 18/14**

(30) Priorität: **05.11.90 DE 4035080**

(43) Veröffentlichungstag der Anmeldung:
**13.05.92 Patentblatt 92/20**

(84) Benannte Vertragsstaaten:
**CH DE FR GB LI NL**

(71) Anmelder: **ABB PATENT GmbH**
**Kallstadter Strasse 1**
**W-6800 Mannheim 31(DE)**

(72) Erfinder: **Esrom, Hilmar, Dr.**
**Auf der Höhe 6**
**W-6803 Edingen-Neckarhausen(DE)**
Erfinder: **Kogelschatz, Ulrich, Dr.**
**Obere Parkstrasse 8**
**CH-5212 Hausen b. Brugg(CH)**

(74) Vertreter: **Rupprecht, Klaus, Dipl.-Ing. et al**
**c/o ABB Patent GmbH, Patentabteilung,**
**Postfach 10 03 51**
**W-6800 Mannheim 1(DE)**

(54) **Verfahren und Einrichtung zur Herstellung von partiellen metallischen Schichten.**

(57) Es werden ein Verfahren bzw. eine Einrichtung von partiellen metallischen Schichten aus einer metallhaltigen, insbesondere metallorganischen Verbindung auf einem Substrat vorgeschlagen, bei dem bzw. bei der die metallhaltige, insbesondere metallorganische Verbindung mit Hilfe einer Schreibvorrichtung (1) mit einer Düse (7) in Form eines Lösungsfilms, der die metallhaltige, insbesondere metallorganische Verbindung enthält, auf die Oberfläche des Substrats (10) aufgetragen wird, wobei die Schreibvorrichtung und das Substrat beliebig in XY-Richtung gegeneinander verschiebbar sind. Anschließend wird die metallhaltige, insbesondere metallorganische Verbindung der Einwirkung von UV-Photonen einer definierten Wellenlänge ausgesetzt. Nachfolgend erfolgt eine Verstärkung der metallischen Schichten (12) durch stromlose chemische oder galvanische Metallisierung.

Rank Xerox (UK) Business Services
(-/2.18/2.0)

Die Erfindung bezieht sich auf ein Verfahren und eine Einrichtung zur Herstellung von partiellen metallischen Schichten aus einer metallhaltigen, insbesondere metallorganischen Verbindung auf einem Substrat durch Bestrahlung mit einer Lichtquelle.

Aus der Mat.RES.Soc.Symp.Proc. Vol. 75, 1987 ist ein Verfahren zur Herstellung von selektiven metallischen Schichten auf einem Substrat bekannt. Zur Ausbildung einer metallischen Schicht auf dem Substrat aus galvanischen Metallisierungsbädern wird das jeweilige Substrat mit einer Lichtquelle hoher Leistung (UV-Strahler) bestrahlt. Für die Fertigstellung der metallischen Schichten sind teure Apparaturen (Laser) erforderlich. Die geringen Schreibgeschwindigkeiten führen zu kleinen Fertigungsraten.

Der Erfindung liegt die Aufgabe zugrunde, ein Verfahren und eine Einrichtung zur Herstellung von partiellen metallischen Schichten anzugeben, mit dem bzw. mit der strukturierte Metallisierungen auf beliebigen Substrat oberflächen einfach, umweltfreundlich und wirtschaftlich aufgebracht werden können.

Diese Aufgabe wird bezüglich des Verfahrens dadurch gelöst, daß die metallhaltige, insbesondere metallorganische Verbindung mit Hilfe einer Schreibvorrichtung in Form eines Lösungsfilms, der die metallhaltige, insbesondere metallorganische Verbindung enthält, auf die Oberfläche des Substrats aufgetragen wird, und daß die metallhaltige, insbesondere metallorganische Verbindung anschließend der Einwirkung von UV-Photonen einer definierten Wellenlänge ausgesetzt wird.

Die Aufgabe wird bezüglich der Einrichtung gelöst durch eine Schreibvorrichtung, der eingangsseitig eine Lösung mit einer metallhaltigen, insbesondere metallorganischen Verbindung zuführbar ist und die ausgangsseitig diese Lösung über eine Düse auf das Substrat aufträgt, wobei Schreibvorrichtung und Substrat beliebig in XYZ-Richtung gegeneinander mit hohen Geschwindigkeiten verschiebbar sind.

Die mit der Erfindung erzielbaren Vorteile bestehen insbesondere darin, daß strukturierte Metallisierungen einer großen Anzahl von Metallen in Feinststrukturtechnik (Strukturen kleiner 100 $\mu$m) (ohne Verwendung aufwendiger Vakuumapparaturen und Masken) auf beliebige Substratoberflächen, wie z.B. keramische Substrate (Al2O3, AlN), Quarz, Glas und Silizium, leichte flexible Kunststoffe (Teflon, Polyimide etc.) Gummi, Kunststoff- oder Glasvliese, keramisch gefüllte oder glasgewebeverstärkte Fluorkunststoffe, Pressboards und Papier oder Pappe mit geringer Temperaturbeständigkeit herstellbar sind. Alle Substratmaterialien sind mit gleich guter Qualität beschichtbar. Die Schichten weisen eine gute Haftfestigkeit und elektrische Leitfähigkeit auf und sind problemlos löt- und bondbar. Der Begriff "Feinststrukturtechnik" umfaßt dabei die Schaffung feinster Leiterbahnen und Strukturen mit sehr engen Abständen, wodurch eine hohe Integrationsdichte erzielt wird. Hierdurch können Bauteile, z.B. Spulen, Solarzellen, Displayzellen etc., miniaturisiert werden. Solche Bauteile mit erhöhter Packungsdichte sind für die Mikroelektronik allgemein, Leiterplattentechnologie, Hybrid- und Sensortechnik sowie für dekorative Anwendung von Interesse. Dabei ist das vorgeschlagene Verfahren relativ wenig zeitaufwendig und sehr wirtschaftlich. Die vorgeschlagene Einrichtung ist bedienungsfreundlich, kostengünstig und schnell bei der Herstellung von Feinststrukturtechnik auf beliebiger Substratoberfläche.

Da alle Verfahrensschritte im Bereich unter 100°C ablaufen, können auch wärmeempfindliche Substratmaterialien beschichtet werden. Dabei wird auch bei topologisch komplexen Oberflächen eine gleichmäßige Beschichtung erzielt. Die verfahrenstechnischen Vorteile wie Reduzierung der Prozeßschrittzahl, Rohstoffeinsparung durch selektive Metallisierung des Basismaterials, Entschärfung der Abwasserprobleme durch Eliminierung von Ätz- und Stripp-Prozessen sowie die Qualitätsverbesserung der Strukturen und letzlich die Wirtschaftlichkeit sprechen für das vorgeschlagenen Verfahren bzw. die vorgeschlagene Einrichtung zur Herstellung von partiellen metallischen Schichten.

Gegenüber der Maskentechnik lassen sich mit dem vorgeschlagenen Verfahren erhebliche Einsparungen bei den verwendeten. z.T. teuren metallorganischen Substanzen erzielen, da von vornherein nur die zu metallisierenden Bereiche mit dem Lösungsmittelfilm benetzt werden.

Vorteilhafte Ausgestaltungen des erfindungsgemäßen Verfahrens bzw. der erfindungsgemäßen Einrichtung sind in den Unteransprüchen gekennzeichnet.

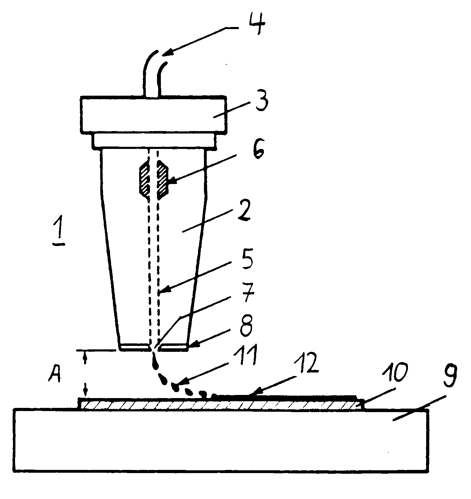

Die Erfindung wird nachstehend anhand des in der Zeichnung dargestellten Ausführungsbeispieles erläutert.

In der einzigen Figur ist eine Schreibvorrichtung 1 zu erkennen mit einem Gehäuse 2 mit Deckel 3 und Boden 8, einem Rohranschluß 4 im Deckel 3 für die Lösungzuführung, einer Kapillare 5, die vom Rohranschluß 4 bis zur Düse 7 im Boden 8 verläuft und mit einem piezoelektrischen Umformer (Transduktor) 6, der die Kapillare 5 umschließt und zum Ausdrücken der Lösung aus der Düse 7 dient. Es können Impulsjets, thermische Jets oder Aerosol Jets verwendet werden, wobei mit Jet ein Flüssigkeitsstrahl bezeichnet wird. Als Schreibgeräte können auch ein Faserstift, ein Kugelschreiber, ein Füllfederhalter oder ein Tuscheschreiber eingesetzt werden.

Die aus der Düse 7 ausgedrückten Flüssigkeitstropfen 11 benetzen das unterhalb der Düse 7 der Schreibvorrichtung angeordnete Substrat 10, wodurch eine "geschriebene" Struktur 12 auf dem Substrat 10 entsteht. Der Abstand A zwischen Düse 7 und Substrat 10 beträgt vorzugsweise 1 mm.

Das Substrat 10 ist vorzugsweise auf einem computergesteuerten XYZ-Verschiebetisch 9 befestigt, so daß durch Verschiebung des Tisches 9 in X- oder Y- oder Z- oder in X- und Y- und Z-Richtung eine beliebige Strukturierung des Substrates 10 mit Lösung möglich ist. Alternativ ist es auch möglich, die Schreibvorrichtung in X- oder Y- oder Z- oder in X- und Y- und Z-Richtung zu verschieben, wobei in diesem Fall das Substrat auf einem feststehenden Tisch zu befestigen ist. Auch ist eine gleichzeitige Verschiebung sowohl der Schreibvorrichtung 1 als auch des Verschiebetisches 9 mit Substrat 10 möglich, wodurch die Strukturierungsgeschwindigkeit weiter erhöht wird.

Gemäß dem ersten Verfahrensschritt zur Herstellung von Feinststrukturen wird demnach ein Schreibverfahren mit flüssigen, metallorganischen oder anderen metallhaltigen Verbindungen in Kombination mit der Computertechnik verwendet, um beliebige Strukturen wie Leiterbahnen, Verbindungen, Spulen, Mäander etc. auf beliebige Oberflächen zu schreiben (Linienbreite z.B. 50 $\mu$m).

Mit computergesteuerten Schreibvorrichtungen können berechnete Metallmuster direkt erzeugt werden. In Verbindung mit einer Abtastvorrichtung (Line scanner) kann man auch eine vorgegebene Zeichnung in ein Metallmuster (z.B. Leiterplatte) umsetzen. Ein weiterer Vorteil der Computertechnik in Verbindung mit der beschriebenen Technologie ist, daß die Schreibvorrichtung über Datenleitungen ferngesteuert werden kann, und daß mehrere solcher Schreibvorrichtungen von einem (evtl. weit entfernten) Computer gesteuert werden können. Eine zentrale Schreibvorrichtung kann von verschiedenen Computern bedient werden.

Als Verbindungen werden metallorganische und andere metallhaltige Verbindungen verwendet, wie Palladiumacetat, Palladiumacetylacetonat, Palladiumchlorid, Cobaltacetat, Nickelacetat, Kupferformeat, Silberneodecanate, Cyclopentadienylpalladiumallyl oder Cyclopentadienylpalladiumchlorid etc., die starke Absorptionsbanden im UV-Bereich von 60 nm bis 400 nm besitzen. Als Lösungsmittel werden z.B. Chloroform, Alkohol, Wasser und andere verwendet.

Die Strahlparameter, insbesondere die Flußrate Q, sind je nach Anwendungsfall einstellbar. Für die Flußrate ergibt sich:

$$Q = f \cdot T \, ( \, R^2 \cdot r_o^2 \cdot K/8\mu L)(1-0.5(r_o/R)^2)(p_1 - p_2)$$

wobei

| | |
|---|---|
| f: | Pulsfrequenz, |
| T: | Pulsdauer, |
| $\mu$:. | Viskosiтät der Lösung, |
| $r_o$: | Radius der Düsenöffnung, |
| R: | Radius der Kapillare, |
| K: | Konstante, |
| | $(p_1 - p_2)$ Druckgradient und |
| L: | Länge der Kapillare. |

Lediglich beispielhaft wird angeführt, daß die Lösung Palladiumacetat enthaltenes Chloroform sein kann. Ferner besteht die Möglichkeit, Cyclopentadienylpalladiumallyl, das in Pulverform vorliegt, in Alkohol oder Wasser zu lösen und auf das Substrat aufzutragen. Die Verwendung von pulverförmigem Cyclopentadienylpalladiumchlorid, das zur Ausbildung einer Lösung ebenfalls in Alkohol oder Wasser gelöst wird, ist ebenfalls möglich. Die Lösungen werden dabei vorzugsweise so dick auf das Substrat aufgetragen, daß die metallische Schicht eine Dicke zwischen 0,5 und 50 nm aufweist.

Bei wasserlöslichen Substanzen kann es zweckmäßiger sein, die aufgetragenen Lösungen (= geschriebene Struktur 12) vor dem Bestrahlen in einem Ofen einzutrocknen.

In einem zweiten Verfahrensschritt wird UV-Strahlung verwendet, um durch Belichten der dünnen metallorganischen Schichtstrukturen die Zersetzung der nichtleitenden metallorganischen Verbindungen zu erzielen und eine Abscheidung der entsprechenden Metalle zu bewirken (UV-unterstützte Abscheidung eines Katalysators aus metallorganischen Adsorbaten auf der Substratoberfläche. Da das ultraviolette Licht im wesentlichen nur mit dem Aktivator auf der Substratoberfläche wechselwirkt, bleibt das Substratmaterial unbeeinflußt. Die Eigenschaften des Substratmaterials spielen bei dem Abscheideprozeß nur eine unwesentiche Rolle. Als UV-Quelle wird vorzugsweise eine inkohärente Excimerlichtquelle mit gewünschter Wellenlänge verwendet. Eine detaillierte Beschreibung eines solchen Hochleistungsstrahlers kann der EP-OS 0 254 111 entnommen werden. Der Hochleistungsstrahler besteht aus einem durch eine einseitig gekühlte Metallelektrode und ein Dielektrium oder zwei Dielektrika begrenzten und mit einem Edelgas oder Gasgemisch gefüllten Entladungsraum. Das Dielektrikum und die auf der dem Entladungsraum abgewandten Oberfläche des Dielektrikums liegende zweite Elektrode sind für die durch stille elektrische Entladung erzeugte Strahlung transparent. Durch diese Konstruktion und durch eine geeignete Wahl der Gasfüllung wird ein großflächiger UV-Hochleistungsstrahler mit hohem Wirkungsgrad geschaffen. Mit einer Gasfüllung aus Xenon kann mit dem Hochleistungsstrahler UV-Strahlung mit einer Wellenlänge zwischen 160 und 190 nm erzeugt werden, wobei das Maximum hierbei bei 172 nm liegt. Mit einer Gasfüllung aus Krypton und Chlor kann UV-Strahlung im Bereich von 210 bis 230 nm erzeugt werden. Mit einem Gasgemisch aus Xenon und Chlor läßt sich mit dem Hochleistungsstrahler eine Wellenlänge von 300 bis 320 nm erzeugen. Der Hochleistungsstrahler arbeitet im quasigepulsten Betrieb. Soll das zu beschichtende Substrat auf seiner gesamten Oberfläche mit einer Metallstruktur versehen werden, so wird ein Hochleistungsstrahler verwendet, dessen Strahlungsfeld der Größe der Substratoberfläche entspricht. Die Bestrahlung kann je nach Gegebenheiten, Auftragungsdicke und Abstand zwischen Substratoberfläche und UV-Hochleistungsstrahler wenige Sekunden bis hin zu einigen Minuten lang durchgeführt werden.

Anstelle des beschriebenen UV-Hochleistungsstrahlers kann auch eine Hochleistungsquecksilberlampe für die Ausbildung der metallischen Schichten eingesetzt werden. Dabei kann die Geometrie des verwendeten UV-Hochleistungsstrahlers bzw. der Hochleistungsquecksilberlampe an die Geometrie der zu beschichtenden Substrate angepaßt werden. Es ist beispielsweise durchaus möglich, die Beschichtung von rechteckigen Substraten im Sekundentakt auf einem Fließband durchzuführen. Hierfür wird die Lampengeometrie auf den rechteckigen Querschnitt des zu beschichtenden Substrates abgestimmt. Zusätzlich werden die Länge der Lampe und die Geschwindigkeit des Bandes, auf welches die Substrate gelegt werden, so aufeinander abgestimmt, daß das jeweilige Substrat solange unter einer Lampe hindurch bewegt wird, wie es für die Ausbildung der metallischen Schicht auf seiner Oberfläche erforderlich ist. Die gewünschte Produktionsrate kann durch Wahl der o.g. Parameter erzielt werden.

In einem dritten Verfahrensschritt werden stromlose chemische Verfahren oder direkte galvanische Verfahren angewendet, um den eigentlichen Schichtaufbau zu bewirken. Dabei können eine Vielzahl von Metallen wie Cu, Ni, Pd, Pt, Al, Au, Cr, Sn etc. strukturiert abgeschieden werden, wobei eine Schichtdicke bis zu einigen 100 $\mu$m erreicht werden kann.

Die aktivierten Bereiche werden in handelsüblichen Bädern stromlos metallisiert. Typische Badtemperaturen liegen im Bereich zwischen Raumtemperatur und 100 °C. Verglichen mit den am weitesten verbreiteten Techniken, Aufdampfen im Vakuum und Sputtern, haben chemische Metallisierungsverfahren neben den zu erzielenden hohen Schichtdicken den wesentlichen Vorteil, daß die Metallisierung kompliziert geformter Werkstücke mit einer homogenen Schichtdickenverteilung möglich ist. Mit Hilfe dieser Technologie ist ist es daher auch möglich, gekrümmte Oberflächen zu metallisieren. Bei den vielfach eingesetzten chemischen Metallisierungsverfahren werden im Vergleich hierzu allein für die Vorbehandlung und Aktivierung der Oberflächen ca. 12 naßchemische Bäder benötigt, bevor das eigentliche Metallisierungsbad angewendet wird (z.B. Shipley Verfahren). Zur Strukturierung der Metallschichten werden dann weitere Prozeßschritte (Beschichten mit Lack, Belichten, Ätzen von Lack- und Metallschichten, Entfernen von Lackresten) benötigt, so daß in nachteiliger Weise insgesamt ca. 20 Prozeßschritte zur Herstellung strukturierter Metallschichten notwendig sind.

Eine für die Serienfertigung geeignete Gesamtanlage zur Herstellung von partiellen metallischen Schichten besteht beispielsweise aus einem computergesteuerten Lösungsstrahlschreiber, einer inkohärenten Excimerstrahlungsquelle und einem chemischen Metallisierungsbad sowie eventuell einem zusätzlichen Mikroskop mit Monitor. Die strukturierten Substrate werden dabei im Durchlaufbetrieb mit hohem Durchsatz gefertigt. Wichtige Anwendungen sind ferner in Schaltkreismodifikationen zu sehen: Reparatur und Abgleich von Schaltungen.

## Patentansprüche

1. Verfahren zur Herstellung von partiellen metallischen Schichten aus einer metallhaltigen, insbesondere metallorganischen Verbindung auf einem Substrat durch Bestrahlung mit einer Lichtquelle, dadurch gekennzeichnet, daß die metallhaltige, insbesondere metallorganische Verbindung mit Hilfe einer Schreibvorrichtung in Form eines Lösungsfilms, der die metallhaltige, insbesondere metallorganische Verbindung enthält, auf die Oberfläche des Substrats aufgetragen wird und daß die metallhaltige, insbesondere metallorganische Verbindung anschließend der Einwirkung von UV-Photonen einer definierten Wellenlänge ausgesetzt wird.

2. Verfahren nach Anspruch 1, dadurch gekennzeichnet, daß zur Herstellung von metallischen Schichten die aufgetragene Lösung der Strahlung eines UV-Strahlers oder UV-Hochleistungsstrahlers ausgesetzt wird.

3. Verfahren nach Anspruch 2, dadurch gekennzeichnet, daß zur Herstellung von metallischen Schichten die aufgetragene Lösung mit einem Hochleistungsstrahler bestrahlt wird, der UV-Strahlung mit einer Wellenlänge zwischen 60 nm und 400 nm erzeugt.

4. Verfahren nach einem der Ansprüche 1 bis 3, dadurch gekennzeichnet, daß zur Herstellung von metallischen Schichten Lösungen verwendet werden, deren Metallanteil durch Palladium, Kupfer, Platin, Cobalt, Nickel, Silber oder Gold gebildet wird.

5. Verfahren nach einem der Ansprüche 1 bis 4, dadurch gekennzeichnet, daß zur Herstellung von metallischen Schichten eine Lösung in Form von Palladiumacetat, Palladiumacetylacetonat, Palladiumchlorid, Cobaltacetat, Nickelacetat, Kupferformeat, Silberneodecanat, Cyclopentadienylpalladiumallyl oder Cyclopentadienylpalladiumchlorid auf das Substrat aufgetragen wird.

6. Verfahren nach einem der Ansprüche 1 bis 5, dadurch gekennzeichnet, daß als Lösungsmittel Chloroform, Alkohol oder Wasser verwendet wird.

7. Verfahren nach einem der Ansprüche 1 bis 6, dadurch gekennzeichnet, daß die metallischen Schichten durch stromlose chemische oder galvanische Metallisierung verstärkt werden.

8. Verfahren nach Anspruch 7, dadurch gekennzeichnet, daß Metalle wie Cu, Ni, Pd, Pt, Al, Au, Cr, Sn strukturiert abgeschieden werden.

9. Verfahren nach einem der Ansprüche 1 bis 8, dadurch gekennzeichnet, daß die partiellen Schichten auf die Oberfläche von Substraten aus organischen oder anorganischen Werkstoffen aufgetragen werden.

10. Einrichtung zur Herstellung von partiellen metallischen Schichten aus einer metallhaltigen, insbesondere metallorganischen Verbindung auf einem Substrat durch Bestrahlung mit einer Lichtquelle, gekennzeichnet durch eine Schreibvorrichtung (1), der eingangsseitig eine Lösung mit einer metallhaltigen, insbesondere metallorganischen Verbindung zuführbar ist und die ausgangsseitig diese Lösung über eine Düse (7) auf das Substrat (10) aufträgt, wobei Schreibvorrichtung (1) und Substrat (10) beliebig in XYZ-Richtung gegeneinander verschiebbar sind.

11. Einrichtung nach Anspruch 10, dadurch gekennzeichnet, daß die Lösung mit Hilfe eines piezoelektrischen Umformers (6) aus der Düse (7) gedrückt wird.

12. Einrichtung nach Anspruch 10 gekennzeichnet durch einen Faserstift als Schreibgerät.

13. Einrichtung nach Anspruch 10, gekennzeichnet durch einen Kugelschreiber als Schreibgerät.

14. Einrichtung nach Anspruch 10, gekennzeichnet durch einen Füllfederhalter als Schreibgerät.

15. Einrichtung nach Anspruch 10, gekennzeichnet durch einen Tuscheschreiber als Schreibgerät.

16. Einrichtung nach einem der Ansprüche 10 bis 15, dadurch gekennzeichnet, daß das Substrat auf einem computergesteuerten Verschiebetisch (9) befestigt ist.

17. Einrichtung nach einem der Ansprüche 10 bis 16, dadurch gekennzeichnet, daß die Schreibvorrichtung (1) computergesteuert in XYZ-Richtung verschiebbar ist.